# FASCICULE DE BREVET EUROPEEN

(11) **EP 1 271 164 B1**
(45) Date de publication et mention de la délivrance du brevet: **18.07.2007**
(21) Numéro de dépôt: 02011358.5
(22) Date de dépôt: 23.05.2002
(51) Int. Cl.: G01R 31/04, G01R 31/308

(54) **Contrôle du sertissage de connexion sur un câble plat et dispositif correspondant**
Krimpverbindungsregelung auf einem Flachkabel und Vorrichtung dafür
Crimping connection control on a flat cable and apparatus therefore

(30) Priorité: 28.06.2001 FR 0108550
(43) Date de publication de la demande: 02.01.2003
(73) Titulaire: S-Y Systems Technologies France SAS, 92257 La Garenne Colombes (FR)
(72) Inventeur: Hellemans, Roel, 32200 Montiron (FR); Rebout, Philippe, 31810 Venerque (FR); Vidal, Alain, 31830 Plaisance du Touch (FR)
(74) Mandataire: Patentanwaltskanzlei WILHELM & BECK

(56) Documents cités:
- EP-A- 0 649 030
- PATENT ABSTRACTS OF JAPAN vol. 1996, no. 12, 26 décembre 1996 (1996-12-26) & JP 08 222043 A (YAZAKI CORP), 30 août 1996 (1996-08-30)

## Description

La présente invention concerne un procédé de contrôle de sertissage de connexion sur un câble plat ainsi qu'un dispositif correspondant pour la mise en oeuvre de ce procédé.

Dans le domaine de la construction automobile, il est connu d'utiliser des câbles plats présentant plusieurs pistes conductrices alignées côte à côte pour assurer l'alimentation électrique de divers équipements. Chaque extrémité du câble plat est alors munie de dispositifs de connexion pour permettre le raccord avec un équipement ou une source d'énergie électrique. Ces dispositifs de connexion sont fixés sur le câble plat par sertissage. La connexion de chaque dispositif de connexion sur le câble plat est réalisée à l'aide de broches métalliques qui traversent la piste conductrice correspondante et sont repliées afin d'assurer un bon contact électrique entre le dispositif de connexion et la piste conductrice.

Les connexions électriques (entre les pistes conductrices et les dispositifs de connexion) ainsi réalisées doivent être testées pour garantir que les broches se trouvent bien au niveau d'une piste conductrice et, le cas échéant, que le sertissage a bien été réalisé de manière à permettre une bonne liaison électrique entre la piste conductrice et le dispositif de connexion. Le test réalisé pour contrôler les connexions est un test électrique. Les deux extrémités du câble plat sont alors connectées électriquement et on vérifie qu'un courant électrique est capable de circuler correctement dans toutes les pistes conductrices.

Ce test électrique est réalisé en fin de chaîne de fabrication du câble plat. Du fait notamment de devoir réaliser une connexion électrique à chaque extrémité du câble plat, ce test électrique réalisé nécessite plusieurs manipulations du câble et le temps de réalisation de ce test est important.

Le document JP 08 222043 décrit un système pour l'inspection d'un câble plat, le système comprenant un éclairage situé au-dessous du câble, un appareil de prise de vues situé au-dessus du câble et des moyens électroniques de traitement d'images.

La présente invention a alors pour but de fournir un procédé permettant d'effectuer un contrôle rapide du sertissage réalisé. Ce procédé devra permettre un contrôle fiable et pourra être réalisé de préférence en ligne, au cours de la fabrication du câble plat.

A cet effet, elle propose un procédé de contrôle d'au moins une connexion électrique réalisée entre un câble plat et un dispositif de connexion par sertissage, le câble comportant des pistes conductrices alignées côte à côte et isolées chacune électriquement vis à vis des pistes voisines et de l'extérieur par une couche d'isolant et chaque dispositif de connexion comportant une patte de sertissage munie de broches destinées à transpercer le câble plat et à être repliées.

Selon l'invention, ce procédé comporte les étapes suivantes :
- mise en place de la connexion sertie à contrôler,
- éclairage du côté des broches repliées d'une première zone du câble plat au niveau de laquelle le sertissage a été réalisé et éclairage par l'autre côté d'une seconde zone du câble, sensiblement voisine de la première,
- prise de vue des deux zones éclairées,
- analyse de la première zone de l'image obtenue pour déterminer la position des broches repliées,
- analyse de la seconde zone de l'image obtenue pour déterminer la position et l'orientation des pistes conductrices,
- détermination de la position relative des broches repliées et des pistes conductrices,
- comparaison du résultat obtenu à une position relative de référence, et
- indication du résultat de l'analyse de l'image en fonction de marges de tolérances prédéterminées.

Un tel procédé peut être mis en oeuvre rapidement en tout point d'une chaîne de fabrication et peut donc aussi être mis en oeuvre juste après la réalisation d'un sertissage. Le fait d'éclairer le câble plat en deux zones distinctes, par des côtés opposés, facilite le traitement et l'analyse de l'image obtenue lors de la prise de vue. En effet, il est ainsi possible de n'avoir que deux niveaux de couleur à analyser permettant aussi d'augmenter la fiabilité de l'analyse.

Dans le procédé de contrôle ci-dessus, la détermination de la position des broches repliées peut être réalisée en identifiant sur l'image obtenue les zones sombres de la première zone éclairée puis en calculant le centre de gravité de chaque zone sombre.

La détermination de la position et de l'orientation des pistes conductrices peut quant à elle être réalisée comme suit :
- en sélectionnant dans la seconde zone éclairée deux bandes parallèles, distantes l'une de l'autre et présentant chacune une intersection avec toutes les pistes conductrices,
- en identifiant pour chacune de ces bandes la position des zones sombres,
- en calculant le centre de gravité de chaque zone sombre, et
- en associant deux à deux à chaque fois une zone sombre d'une première bande avec une zone sombre de la seconde bande correspondant à la même piste conductrice et en alignant les deux centres de gravité pour obtenir l'axe de la piste correspondante.

Le procédé de contrôle selon l'invention peut aussi être utilisé pour contrôler des paramètres géométriques du câble plat. Ainsi l'image obtenue lors de la prise de vue est par exemple analysée pour déterminer la position des bords du câble plat et pour chaque bord longitudinal la distance entre ce bord et la première piste conductrice voisine peut être déterminée. Dans ce procédé, on peut également prévoir que la position des bords est analysée pour déterminer si le bord transversal portant les dispositifs de connexion est perpendiculaire aux bords longitudinaux du câble plat. Tout ceci permet de vérifier qu'au cours du sertissage aucun des bords du câble plat n'a été plié et que le câble est bien découpé à son extrémité.

Pour parfaire la fiabilité du contrôle effectué, on peut prévoir que lors du sertissage, la course de l'outil de sertissage est mesurée et que toute variation de course en dehors d'une plage prédéterminée est signalée. La course mesurée est un indice permettant de déterminer si le contact électrique entre les broches repliées et les pistes conductrices est bon ou non.

La présente invention concerne aussi un dispositif de contrôle pour la mise en oeuvre d'un procédé tel que décrit ci-dessus. Selon l'invention, ce dispositif est caractérisé en ce qu'il comporte :
- un support transparent au moins localement et destiné à recevoir une extrémité de câble plat munie de dispositifs de connexion,
- un éclairage de chaque côté du support,
- un appareil de prise de vues faisant face au support, et
- des moyens électroniques de traitement d'images et de calcul.

Dans un tel dispositif, le support est de préférence disposé horizontalement et est avantageusement équipé de moyens permettant de maintenir un câble plat sur le support.

Pour obtenir un bon éclairage du câble, au moins un éclairage est par exemple constitué par au moins une rampe de diodes lumineuses.

L'éclairage du support, du côté opposé à l'appareil de prise de vue, est avantageusement réalisé par un film électroluminescent. Ceci permet d'avoir un encombrement minimal et facilite donc l'intégration du dispositif de contrôle à un poste de sertissage.

L'appareil de prise de vues utilisé est par exemple une caméra vidéo.

Pour l'éclairage de la face du câble se trouvant du côté de l'appareil de prise de vues, le dispositif selon l'invention comporte par exemple, entre le support et l'appareil de prise de vues, un miroir semi-réfléchissant incliné par rapport au support, et l'éclairage disposé du côté de l'appareil de prise de vue éclaire alors le support par réflexion sur le miroir.

La présente invention concerne également un dispositif de sertissage destiné à la réalisation de connexions électriques sur des câbles plats, caractérisé en ce qu'il est muni d'un dispositif de contrôle tel que décrit plus haut.

Ce dispositif de sertissage est avantageusement également muni d'un dispositif permettant de mesurer précisément la course de l'outil réalisant le sertissage. Ce dispositif de mesure mesure soit effectivement la course de l'outil de sertissage ou bien il peut également mesurer la distance minimale entre cet outil et un bâti sur lequel repose le câble à sertir. Ces deux mesures sont équivalentes pour l'homme du métier.

Les détails et avantages de la présente invention ressortiront mieux de la description qui suit, faite en référence au dessin schématique annexé sur lequel :
Figure 1 est une vue schématique montrant un poste de sertissage associé à un poste de contrôle,
Figure 2 est une vue schématique correspondant à la figure 1 pour une variante de réalisation du poste de contrôle,
Figure 3 montre en vue de dessous un câble plat, et
Figure 4 illustre le procédé de contrôle optique selon l'invention.
Figure 5 monte à échelle agrandie le câble plat de la figure 3 en vue de côté, et
Figure 6 est une vue de dessus correspondant à la figure 5.

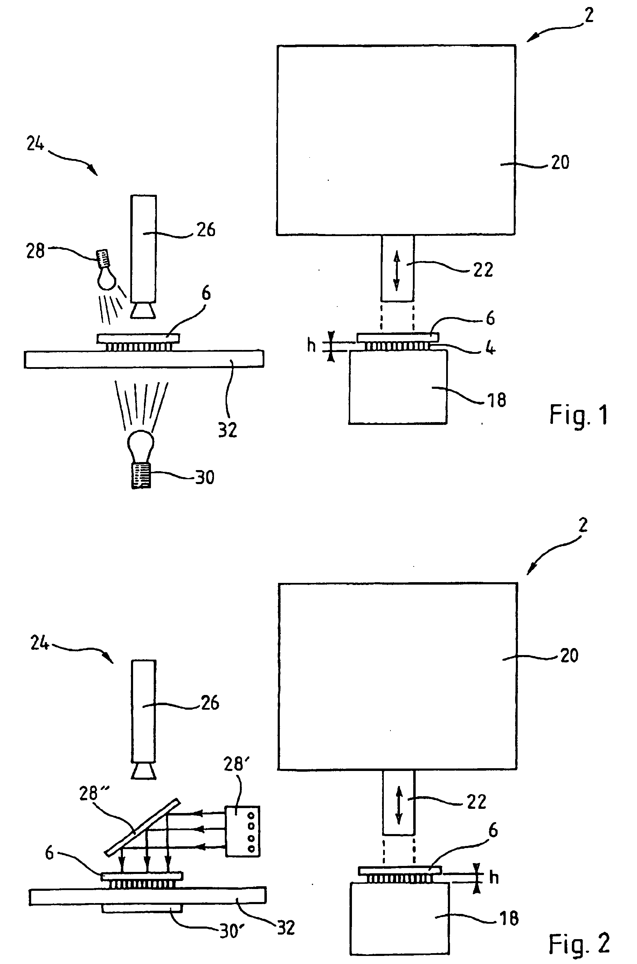

Les figures 1 et 2 montrent un poste de sertissage 2 destiné à réaliser le sertissage de dispositifs de connexion 4 sur un câble plat 6.

Un câble plat 6 se présente sous la forme d'un ruban comportant deux faces entre lesquelles sont prises en sandwich des pistes conductrices 8, elles aussi planes. Ce type de câble est parfois appelé FLC (Flat Laminated Cable soit câble laminé plat). De tels câbles peuvent être utilisés dans l'industrie automobile pour alimenter en énergie électrique certains équipements, par exemple des lumières à l'intérieur de l'habitacle.

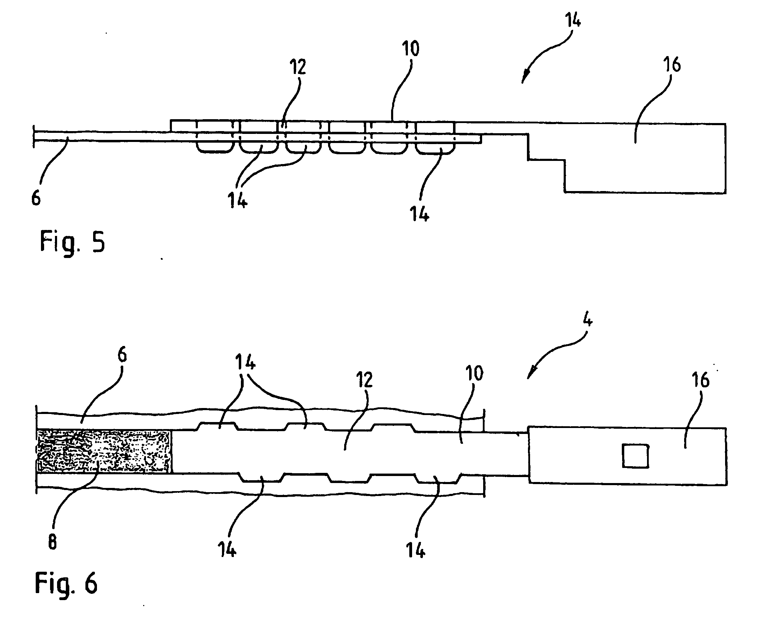

Comme le montrent les figures 5 et 6, chaque dispositif de connexion 4 comporte d'une part une prise femelle 16 destinée à recevoir une fiche mâle correspondante non représentée et d'autre part une patte de sertissage 10. La prise femelle 16 est de forme adaptée à une fiche mâle correspondante. Elle se présente par exemple sous une forme parallélépipédique avec en son centre un logement (non représenté) s'étendant longitudinalement. Des moyens élastiques non représentés assurent un bon maintien de la fiche mâle une fois celle-ci introduite dans la prise femelle 16. Une telle prise femelle est connue de l'homme du métier et n'est pas décrite plus en détail ici.

Chaque patte de sertissage 10 se présente sous la forme d'une bande de tôle 12 sensiblement plane à partir de laquelle s'étendent des broches 14 repliées perpendiculairement au plan de la bande de tôle 12 (figures 5 et 6). La bande de tôle 12 a une largeur sensiblement égale à celle d'une piste conductrice 8 d'un câble plat 6 sur lequel le dispositif de connexion 4 correspondant est destiné à être fixé.

Pour fixer un dispositif de connexion 4 sur un câble plat 6, le dispositif de connexion 4 est disposée en bout de câble de telle sorte que la bande de tôle 12 soit positionnée au-dessus d'une piste conductrice 8, la piste 8 et la bande 12 étant parallèles. Les broches 14 sont orientées vers la piste conductrice 8. Pour réaliser le sertissage du dispositif de connexion sur le câble plat 6, les broches 14 viennent traverser le câble plat 6 et sont ensuite repliées sur la piste conductrice 8 correspondante. Le poste de sertissage 2 comporte à cet effet une presse à sertir. Cette presse comprend d'une part un bâti 18 rigide destiné à supporter un câble 6 et les dispositifs de connexion 4 correspondants et d'autre part un outil de presse 20 équipé d'une tête de sertissage 22.

Le poste de sertissage 2 est équipé d'une unité de contrôle optique 24. Cette dernière comprend une caméra vidéo 26, un éclairage supérieur 28, un éclairage inférieur 30 ainsi qu'un support 32 transparent.

Le support transparent 32 est disposé horizontalement et on supposera dans la suite de la description que les câbles plats posés sur ce support 32 le sont de telle sorte que la face supérieure du câble plat 6 comporte les broches 14 repliées tandis que la face inférieure du câble plat 6, c'est-à-dire celle en contact avec le support transparent 32, porte les bandes de tôle 12.

La caméra vidéo 26 est disposée au-dessus du support transparent 32 et est orientée verticalement vers ce support 32.

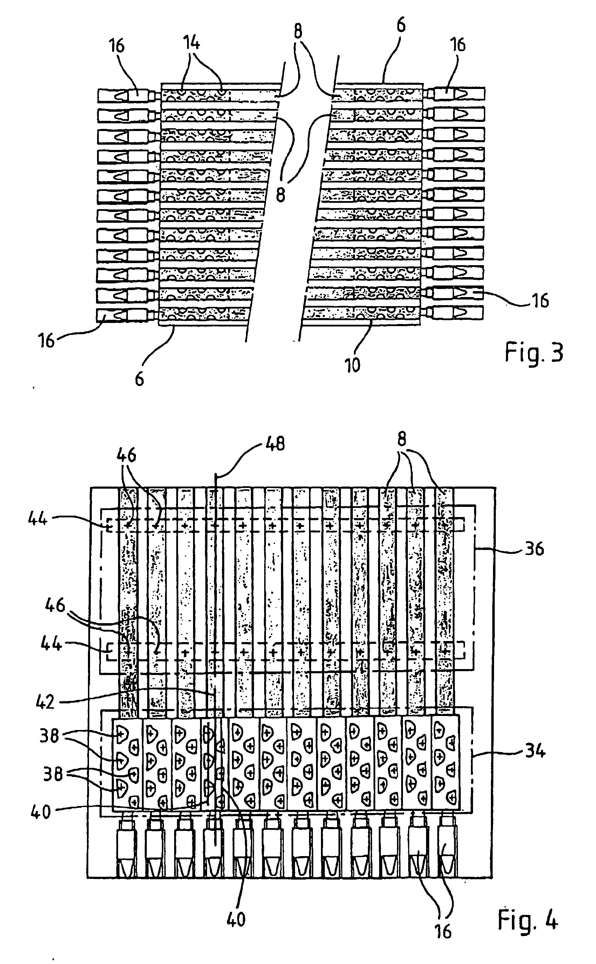

L'éclairage supérieur 28 illumine une première zone 34 de la face supérieure du câble plat 6. Cette zone est représentée en trait mixte sur la figure 4. Cette zone 34 est constituée en fait par l'extrémité du câble plat. Cette zone 34 éclairée comprend toutes les broches 14 repliées sur les pistes conductrices 8 correspondantes.

L'éclairage inférieur 30 illumine au travers du support transparent 32 une seconde zone 36 du câble plat. Il s'agit d'une zone voisine de la première zone 34. Cette seconde zone 36 couvre toute la largeur du câble plat 6 et s'étend sur une longueur non négligeable du câble, par exemple environ 2 cm. Elle est également représentée en trait mixte sur la figure 4.

La figure 2 montre une forme de réalisation préférée de l'unité de contrôle optique. Dans cette variante, l'éclairage supérieur est réalisé par une boîte à diodes 28'. La lumière émise par cette boîte à diodes s'étend parallèlement au support transparent 32, c'est-à-dire horizontalement, vers un miroir semi-réfléchissant 28". La boîte à diodes 28' et le miroir semi-réfléchissant 28" sont disposés de manière à réaliser l'éclairage du câble plat 6 se trouvant sur le support 32. La caméra 26 filme le câble 6 à travers le miroir semi-réfléchissant 28".

En ce qui concerne l'éclairage inférieur sur la figure 2, celui-ci est assuré par un film électroluminescent 30'. Ce film est disposé sous le support transparent 32 à l'endroit devant être éclairé par le dessous. L'utilisation d'un tel film électroluminescent permet de conserver un encombrement vertical du dispositif d'éclairage très faible.

Pour réaliser un contrôle optique d'un sertissage réalisé par le poste de sertissage 2, un câble 6 venant d'être serti est placé sur le support transparent 32. Des guides et butées, non représentés au dessin, peuvent être prévus pour faciliter la mise en place du câble sur son support et garantir son bon positionnement. Cette opération peut être réalisée manuellement ou automatiquement en fin de sertissage.

Une fois le câble bien positionné, il est illuminé par les dispositifs d'éclairage supérieur 28 et inférieur 30 et une prise de vue est réalisée à l'aide de la caméra vidéo 26. On remarque ici que cette caméra vidéo pourrait être remplacée par un autre dispositif de prise de vue tel par exemple un appareil photo numérique. Sur la prise de vue réalisée, on voit apparaître dans la première zone 34 les broches 14 qui forment des taches sombres sur un fond clair (on suppose ici que le câble plat est de couleur claire) et dans la seconde zone 36 apparaissent des bandes sombres qui correspondent aux pistes conductrices 8 sur un fond clair.

L'image obtenue lors de cette prise de vue, qui est de préférence déjà une image sous forme numérique, est alors analysée par les moyens électroniques pour déterminer si le sertissage réalisé est correct ou non. Il importe ici de déterminer si les broches de sertissage 14 des diverses connexions 4 sont correctement positionnées par rapport aux pistes conductrices 8 correspondantes.

Dans l'exemple de réalisation représenté au dessin, chaque patte de sertissage 10 comporte six broches de sertissage 14 réparties sur les deux bords longitudinaux de la bande de tôle 12 correspondante. Dans le sens longitudinale de cette bande de tôle 12, on trouve donc alternativement sur un bord puis l'autre bord longitudinal de cette bande 12 une broche 14.

L'analyse de l'image obtenue lors de la prise de vue, comprend trois parties : une analyse de la première zone illuminée 34, une analyse de la seconde zone illuminée 36 et une comparaison des résultats obtenus lors de ces deux analyses pour déterminer si le sertissage a été correctement réalisé ou non.

L'analyse de la première zone illuminée 34 se fait en distinguant sur l'image obtenue les taches sombres du fond clair. Une fois les taches sombres identifiées, un calculateur détermine pour chacune de ces taches le centre de gravité de celles-ci. Une croix 38 symbolise le centre de gravité sur la figure 4. A chaque bord longitudinal d'une bande de tôle 12 d'un dispositif de connexion 4, correspondent trois broches de sertissage 14 et donc trois croix 38. Le calculateur détermine alors la ligne moyenne 40 passant par ces trois croix 38. Pour deux bords correspondant à une même connexion, on détermine ensuite la ligne médiane 42 des deux lignes moyennes 40 calculées précédemment.

L'analyse de la seconde zone éclairée 36 a pour but de déterminer l'axe des pistes conductrices 8. Pour ce faire, le dispositif électronique d'analyse observe deux fines bandelettes transversales 44. Ces bandelettes sont perpendiculaires à la position théorique des pistes conductrices 8 et s'étendent sur toute la largeur du câble plat 6. Chacune de ces bandelettes présente une succession de zones claires et de zones sombres, les zones sombres correspondants aux pistes conductrices 8. Sur chacune de ces bandelettes, on détermine le centre de gravité de chaque zone sombre. Ces centres de gravité sont chacun symbolisés sur la figure 4 par une croix 46. En associant à chaque fois une croix 46 d'une première bandelette 44 avec une croix 46 de la seconde bandelette 44, on peut déterminer une droite 48 qui correspond théoriquement à l'axe de la piste conductrice 8.

On comprend ici que la seconde zone illuminée 36 doit s'étendre sur une longueur suffisante du câble pour pouvoir déterminer de manière précise l'emplacement, la direction et les dimensions des pistes conductrices 8 du câble plat 6. Les bandelettes 44 seront choisies relativement au bord de la seconde zone illuminée 36 de manière à être assez distantes l'une de l'autre pour minimiser les erreurs dues à l'imprécision du calcul de la position des croix 46.

Idéalement, à chaque ligne 48 correspondant à une piste conductrice 8 correspond une ligne médiane 42 et ces deux lignes sont confondues. Bien entendu, des tolérances sont prédéterminées tant en ce qui concerne un décalage transversal de la ligne 48 calculée avec la ligne médiane 42 obtenue précédemment que pour une variation angulaire entre ces deux lignes. Des plages de tolérance sont ainsi déterminées. Si le décalage transversal et l'angle que font entre elles les lignes 48 et 42 se trouvent dans ces plages prédéterminées, on estimera que le contact réalisé lors du sertissage est bon.

La comparaison de la position relative des lignes 42 et 48 avec la position de référence (dans laquelle ces deux lignes sont confondues) est effectuée pour chaque connexion. Lorsque toutes les comparaisons ont été effectuées, un afficheur (non représenté) indique le résultat du contrôle. Ce résultat est aussi mémorisé pour pouvoir effectuer un suivi des sertissages réalisés au niveau du poste 2.

La description faite ci-dessus permet d'observer le bon alignement des dispositifs de connexion 4 sur les pistes conductrices 8. Lors de l'analyse des zones 34 et 36 de l'image obtenue, il est possible de faire également d'autres vérifications. Il est ainsi possible par exemple de vérifier que toutes les broches 14 sont présentes, que toutes les broches ont été repliées du bon côté et non pas vers une piste voisine. Cette analyse permet également de contrôler le nombre de pistes conductrices et si la largeur de celles-ci correspond à la largeur attendue. Ces vérifications peuvent être réalisées avec les mesures effectuées ci-dessus.

D'autres mesures sont également envisageables. On peut ainsi, sur l'image obtenue, identifier les bords du câble plat 6. Il est alors envisageable de vérifier que les bords longitudinaux de ce câble 6 sont sensiblement parallèles aux pistes conductrices 8. Quant au bord transversal du câble plat 6, on peut regarder si celui-ci est bien orthogonal aux bords longitudinaux du câble plat 6. Ceci permet alors de contrôler la qualité de la découpe du câble plat et que le câble n'a pas été plié lors du sertissage. Ces contrôles supplémentaires sont optionnels. Le fait de pouvoir les réaliser est un avantage du procédé de contrôle proposé par l'invention.

Pour contrôler la qualité des connexions électriques réalisées par sertissage au niveau du poste de sertissage 2, il est également proposé de compléter, en option, le contrôle optique décrit ci-dessus. Le contrôle supplémentaire proposé consiste à mesurer précisément la course de la tête de sertissage 22. Un dispositif de mesure est alors intégré à l'outil de presse 20. Ce dispositif permet de mesurer la distance h séparant le support 18 de la tête de sertissage 22 au moment où celle-ci est en position la plus basse (figures 1 et 2). Cette mesure permet de donner un indice sur la qualité du sertissage pour déterminer si les broches 14 ont été ou non correctement comprimées. En effet, si la mesure h est trop faible, l'appui sur les broches 14 est trop fort et il y a risque d'écrasement de ces broches. Par contre, si la mesure h est trop grande, les broches 14 risquent de ne pas être serties (repliées) correctement et le contact électrique entre la broche 14 et la piste 8 correspondante n'est peut être pas établi.

La connaissance de cette mesure h permet d'augmenter la fiabilité du contrôle de la qualité du sertissage effectué au niveau du poste de sertissage 2.

Le dispositif décrit ci-dessus ainsi que le procédé correspondant permettent de réaliser un excellent contrôle, fiable, de la qualité de connexions 4 électriques réalisées par un poste de sertissage sur un câble plat 6. Le fait d'éclairer le câble plat 6 en deux zones 34, 36 distinctes, par des côtés opposés, facilite l'analyse et le traitement de l'image obtenue par la caméra 26. Pour chaque zone 34, 36 à analyser, seuls deux niveaux de couleur sont à analyser. Il suffit dans chaque analyse de distinguer une couleur claire d'une couleur foncée. La caméra 26 peut alors utiliser l'ensemble de ses niveaux de sensibilité (par exemple ses niveaux de gris) pour bien distinguer ces deux seules couleurs. Ainsi, la fiabilité de l'analyse de l'image est maximale.

Le contrôle du sertissage effectué comme indiqué ci-dessus peut être réalisé très rapidement et sans pénaliser les temps de production. L'unité de contrôle peut être associée directement au poste de sertissage. On détecte ainsi immédiatement un sertissage défectueux. La pièce défectueuse peut ainsi être immédiatement retirée de la chaîne de fabrication avant même que d'autres opérations ne soient effectuées. Ceci permet de réaliser des économies sensibles par rapport à contrôle électrique effectué en fin de chaîne de production. En outre, si plusieurs pièces mauvaises sont détectées à la suite, ou dans un bref intervalle, la station de sertissage peut être stoppée pour être contrôlée.

Comme indiqué plus haut, l'analyse de la prise de vue présente aussi l'avantage de pouvoir réaliser des tests qui, jusqu'à présent, ne sont pas effectués sur des câbles plats. On peut citer ici par exemple le contrôle de la bonne découpe du câble.

La présente invention ne se limite pas au dispositif et au procédé décrits ci-dessus à titre d'exemples non limitatifs. Elle concerne également toutes les variantes de dispositifs et de procédés à la portée de l'homme du métier dans le cadre des revendications ci-après.

Ainsi par exemple, le câble peut être tourné différemment sur le support transparent. Il suffit alors de changer en conséquence les positions des éclairages et de la caméra. Le câble peut être en position horizontale ou verticale ou dans toute autre position.

De même le contrôle peut être effectué sur les câbles plats de tous types et avec des connexions serties avec des broches de toutes formes. Ce contrôle peut être effectué aussi pour tous les types de dispositifs de connexion destinés à être monté par sertissage sur une extrémité de câble plat.

## Revendications

1. Procédé de contrôle d'au moins une connexion électrique réalisée entre un câble plat (6) et un dispositif de connexion (4) par sertissage, le câble comportant des pistes conductrices (8) alignées côte à côte et isolées chacune électriquement vis à vis des pistes voisines et de l'extérieur par une couche d'isolant et chaque dispositif de connexion (4) comportant une patte de sertissage (10) munie de broches (14) destinées à transpercer le câble plat (6) et à être repliées, le procédé comportant les étapes suivantes :
- mise en place de la connexion sertie à contrôler,
- éclairage du côté des broches (14) repliées d'une première zone (34) du câble plat (6) au niveau de laquelle le sertissage a été réalisé et éclairage par l'autre côté d'une seconde zone (36) du câble, sensiblement voisine de la première,
- prise de vue des deux zones éclairées,
- analyse de la première zone (34) de l'image obtenue pour déterminer la position des broches (14) repliées,
- analyse de la seconde zone (36) de l'image obtenue pour déterminer la position et l'orientation des pistes conductrices (8),
- détermination de la position relative des broches (14) repliées et des pistes conductrices (8),
- comparaison du résultat obtenu à une position relative de référence, et
- indication du résultat de l'analyse de l'image en fonction de marges de tolérances prédéterminées.

2. Procédé de contrôle selon la revendication 1, **caractérisé en ce que** la détermination de la position des broches (14) repliées est réalisée en identifiant sur l'image obtenue les zones sombres de la première zone (34) éclairée puis en calculant le centre de gravité (38) de chaque zone sombre.

3. Procédé de contrôle selon l'une des revendications 1 ou 2, **caractérisé en ce que** la détermination de la position et de l'orientation des pistes conductrices (8) est réalisée comme suit :
- en sélectionnant dans la seconde zone (36) éclairée deux bandes (44) parallèles, distantes l'une de l'autre et présentant chacune une intersection avec toutes les pistes conductrices (8),
- en identifiant pour chacune de ces bandes (44) la position des zones sombres,
- en calculant le centre de gravité (46) de chaque zone sombre, et
- en associant deux à deux à chaque fois une zone sombre d'une première bande avec une zone sombre de la seconde bande correspondant à la même piste conductrice (8) et en alignant les deux centres de gravité (46) pour obtenir l'axe (48) de la piste correspondante.

4. Procédé de contrôle selon l'une des revendications 1 à 3, **caractérisé en ce que** lors du sertissage, la course de l'outil de sertissage (22) est mesurée et **en ce que** toute variation de course en dehors d'une plage prédéterminée est signalée.

5. Dispositif de contrôle pour la mise en oeuvre d'un procédé selon l'une des revendications 1 à 4, le dispositifs de contrôle comportant:
- un support (32) transparent au moins localement et destiné à recevoir une extrémité de câble plat (6) muni munie de dispositifs de connexion,
- un éclairage (28, 30 ; 28', 30') de chaque côté du support,
- un appareil de prise de vues (26) faisant face au support (32), et
- des moyens électroniques de traitement d'images et de calcul.

6. Dispositif de contrôle selon la revendication 5, **caractérisé en ce que** le support (32) est disposé horizontalement et est équipé de moyens permettant de maintenir un câble plat (6) sur le support (32).

7. Dispositif de contrôle selon l'une des revendications 5 ou 6, **caractérisé en ce qu'**au moins un éclairage (28) est constitué par au moins une rampe de diodes lumineuses.

8. Dispositif de contrôle selon l'une des revendications 5 à 7, **caractérisé en ce que** l'éclairage du support, du côté opposé à l'appareil de prise de vue, est réalisé par un film électroluminescent (30').

9. Dispositif de contrôle selon l'une des revendications 5 à 8, **caractérisé en ce que** l'appareil de prise de vues est une caméra vidéo (26).

10. Dispositif de contrôle selon l'une des revendications 5 à 9, **caractérisé en ce qu'**il comporte, entre le support (32) et l'appareil de prise de vues (26), un miroir semi-réfléchissant (28") incliné par rapport au support (32), et **en ce que** l'éclairage (28') disposé du côté de l'appareil de prise de vue éclaire le support par réflexion sur le miroir.

11. Dispositif de sertissage (2) destiné à la réalisation de connexions électriques sur des câbles plats (6), **caractérisé en ce qu'**il est muni d'un dispositif de contrôle (24) selon l'une des revendications 5 à 10.

12. Dispositif de sertissage selon la revendication 11, **caractérisé en ce qu'**il comporte un dispositif permettant de mesurer précisément la course (h) de son outil (22) réalisant le sertissage.

## Claims

1. Method of checking at least one electrical connection made between a flat cable (6) and a connection device (4) by crimping, the cable having conducting tracks (8) aligned side by side and each electrically isolated from the neighbouring tracks and from the outside by an insulation layer and each connection device (4) comprising a crimping lug (10) provided with pins (14) designed to transpierce the flat cable (6) and to be bent over, the method comprising the following steps:
- the installation of the crimped connection to be checked;
- illumination, on the side with the bent-over pins (14), of a first zone (34) of the flat cable (6) in which the crimping was carried out and illumination, via the other side, of a second zone (36) of the cable, quite close to the first;
- images of the two illuminated zones are taken;
- analysis of the first zone (34) from the image obtained, in order to determine the position of the bent-over pins (14);
- analysis of the second zone (36) from the image obtained, in order to determine the position and the orientation of the conducting tracks (8);
- determination of the relative position of the bent-over pins (14) and the conducting tracks (8);
- comparison of the result obtained with a reference relative position; and
- indication of the result of the image analysis according to predetermined tolerance margins.

2. Checking method according to Claim 1, **characterized in that** the position of the bent-over pins (14) is determined by identifying, in the image obtained, the dark areas of the first illuminated zone (34) and then by calculating the centre of gravity (38) of each dark area.

3. Checking method according to either of Claims 1 and 2, **characterized in that** the position and the orientation of the conducting tracks (8) are determined as follows:
- by selecting, in the second illuminated zone (36), two parallel bands (44) a certain distance apart and each having an intersection with all the conducting tracks (8);
- by identifying the position of the dark areas for each of these bands (44);
- by calculating the centre of gravity (46) of each dark area; and
- by associating each time, pairwise, a dark area of a first band with a dark area of the second band corresponding to the same conducting track (8) and by aligning the two centres of gravity (46) in order to obtain the axis (48) of the corresponding track.

4. Checking method according to one of Claims 1 to 3, **characterized in that**, during crimping, the travel of the crimping tool (22) is measured and **in that** any variation in travel outside a predetermined range is signalled.

5. Checking device for implementing a method according to one of Claims 1 to 4, the checking device comprising:
- an at least locally transparent support (32) designed to accommodate one end of the flat cable (6), said end being provided with connection devices;
- an illumination (28, 30; 28', 30') on each side of the support;
- a camera (26) facing the support (32); and
- electronic image-processing and calculating means.

6. Checking device according to Claim 5, **characterized in that** the support (32) is placed horizontally and is equipped with means for holding a flat cable (6) on the support (32).

7. Checking device according to either of Claims 5 and 6, **characterized in that** at least one illumination (28) consists of at least one array of light-emitting diodes.

8. Checking device according to one of Claims 5 to 7, **characterized in that** the support is illuminated on the opposite side from the camera by an electroluminescent film (30').

9. Checking device according to one of Claims 5 to 8, **characterized in that** the camera is a video camera (26).

10. Checking device according to one of Claims 5 to 9, **characterized in that** it includes, between the support (32) and the camera (26), a semi-reflecting mirror (28") inclined to the support (32) and **in that** the illumination (28') placed on the same side as the camera illuminates the support by reflection off the mirror.

11. Crimping device (2) intended for making electrical connections on flat cables (6), **characterized in that** it is provided with a checking device (24) according to one of Claims 5 to 10.

12. Crimping device according to Claim 11, **characterized in that** it includes a device allowing the travel (h) of its crimping tool (22) to be measured precisely.

## Patentansprüche

1. Verfahren zur Steuerung mindestens eines elektrischen Anschlusses, der durch Crimpen zwischen einem Flachkabel (6) und einer Anschlussvorrichtung (4) hergestellt wird, wobei das Kabel Leiterbahnen (8) aufweist, die nebeneinander ausgerichtet sind und die jeweils elektrisch gegenüber den benachbarten Bahnen und gegenüber außen durch eine Isolierschicht isoliert sind und wobei jede Anschlussvorrichtung (4) eine Crimplasche (10) aufweist, die mit Stiften (14) versehen ist, die das Flachkabel (6) durchbohren sollen und umgebogen werden sollen,
wobei das Verfahren folgende Schritte aufweist:
- Einrichtung des zu steuernden vercrimpten Anschlusses,
- Beleuchtung auf der Seite der umgebogenen Stifte (14) eines ersten Bereichs (34) des Flachkabels (6), in dem der Crimpvorgang erfolgte, und Beleuchtung von der anderen Seite eines zweiten Bereichs (36) des Kabels, der sich im Wesentlichen neben dem ersten Bereich befindet,
- Aufnahme der beiden beleuchteten Bereiche,
- Analyse des ersten Bereichs (34) des erhaltenen Bildes, um die Position der umgebogenen Stifte (14) festzulegen,
- Analyse des zweiten Bereichs (36) des erhaltenen Bildes, um die Position und die Ausrichtung der Leiterbahnen (8) festzulegen,
- Festlegung der relativen Position der umgebogenen Stifte (14) und der Leiterbahnen (8),
- Vergleich des erzielten Ergebnisses mit einer relativen Bezugsposition, und
- Angabe des Ergebnisses der Analyse des Bildes in Abhängigkeit von vorgegebenen Toleranzbereichen.

2. Steuerungsverfahren nach Anspruch 1, **dadurch gekennzeichnet, dass** die Festlegung der Position der umgebogenen Stifte (14) **dadurch** erfolgt, dass auf dem erzielten Bild die dunklen Bereiche des ersten beleuchteten Bereichs (34) bestimmt werden und dann der Schwerpunkt (38) der einzelnen dunklen Bereiche berechnet wird.

3. Steuerungsverfahren nach einem der Ansprüche 1 oder 2, **dadurch gekennzeichnet, dass** die Festlegung der Position und der Ausrichtung der Leiterbahnen (8) wie folgt durchgeführt wird:
- Auswahl von zwei parallelen Streifen (44) im zweiten beleuchteten Bereich (36), die voneinander entfernt sind und die jeweils eine Kreuzung mit allen Leiterbahnen (8) aufweisen,
- Bestimmung der Position der dunklen Bereiche für jeden dieser Streifen (44),
- Berechnung des Schwerpunkts (46) der einzelnen dunklen Bereiche, und
- jeweils paarweise Zuordnung eines dunklen Bereichs eines ersten Streifens zu einem dunklen Bereich des zweiten Streifens, das derselben Leiterbahn (8) entspricht, und Ausrichtung der beiden Schwerpunkte (46), um die Achse (48) der entsprechenden Bahn zu erhalten.

4. Steuerungsverfahren nach einem der Ansprüche 1 bis 3, **dadurch gekennzeichnet, dass** bei dem Crimpvorgang der Weg des Crimpwerkzeugs (22) gemessen wird und dass jede Abweichung des Weges von einem vorgegebenen Bereich angezeigt wird.

5. Steuerungsvorrichtung zur Durchführung eines Verfahrens nach einem der Ansprüche 1 bis 4, wobei die Steuerungsvorrichtung Folgendes aufweist:
- einen mindestens lokal durchsichtigen Träger (32), der ein Ende des Flachkabels (6), das mit Anschlussvorrichtungen versehen ist, aufnehmen soll,
- eine Beleuchtung (28, 30; 28', 30') auf jeder Seite des Trägers,
- ein Aufnahmegerät (26), das sich gegenüber dem Träger (32) befindet, und
- elektronische Mittel zur Bildbearbeitung und Berechnung.

6. Steuervorrichtung nach Anspruch 5, **dadurch gekennzeichnet, dass** der Träger (32) waagerecht angeordnet und mit Mitteln versehen ist, mit denen ein Flachkabel (6) auf dem Träger (32) gehalten werden kann.

7. Steuervorrichtung nach einem der Ansprüche 5 oder 6, **dadurch gekennzeichnet, dass** mindestens eine Beleuchtung (28) aus mindestens einer Rampe aus Leuchtdioden gebildet ist.

8. Steuervorrichtung nach einem der Ansprüche 5 bis 7, **dadurch gekennzeichnet, dass** die Beleuchtung des Trägers auf der gegenüberliegenden Seite des Aufnahmegeräts durch einen elektrolumineszierenden Film (30') erfolgt.

9. Steuervorrichtung nach einem der Ansprüche 5 bis 8, **dadurch gekennzeichnet, dass** das Aufnahmegerät eine Videokamera (26) ist.

10. Steuervorrichtung nach einem der Ansprüche 5 bis 9, **dadurch gekennzeichnet, dass** sie zwischen dem Träger (32) und dem Aufnahmegerät (26) einen Spionspiegel (28"), der im Verhältnis zum Träger (32) geneigt ist, aufweist, und dass die Beleuchtung (28'), die auf der Seite des Aufnahmegeräts angeordnet ist, den Träger durch Reflexion auf dem Spiegel beleuchtet.

11. Crimpvorrichtung (2) zur Herstellung elektrischer Anschlüsse auf Flachkabeln (6), **dadurch gekennzeichnet, dass** sie mit einer Steuervorrichtung (24) nach einem der Ansprüche 5 bis 10 versehen ist.

12. Crimpvorrichtung nach Anspruch 11, **dadurch gekennzeichnet, dass** sie eine Vorrichtung aufweist, mit der der Weg (h) ihres Werkzeugs (22), das den Crimpvorgang durchführt, genau gemessen werden kann.
